# EUROPEAN PATENT SPECIFICATION

(11) **EP 1 943 662 B1**
(45) Date of publication and mention of the grant of the patent: **23.11.2016**
(21) Application number: 06783922.5
(22) Date of filing: 14.09.2006
(51) Int. Cl.: H01J 37/317

(54) **LITHOGRAPHY SYSTEM, SENSOR AND MEASURING METHOD**
LITHOGRAPHIESYSTEM, SENSOR UND MESSVERFAHREN
SYSTEME LITHOGRAPHIQUE, DETECTEUR ET PROCEDE DE MESURE ASSOCIES

(30) Priority: 15.09.2005 NL 1029963; 15.09.2005 US 718143 P
(43) Date of publication of application: 16.07.2008
(73) Proprietor: Mapper Lithography IP B.V., 2628 XK Delft (NL)
(72) Inventor: KRUIT, Pieter, NL-2611 EB Delft (NL); WIELAND, Marco Jan-Jaco, 2628 XK Delft (NL); SLOT, Erwin, NL-2728 AN Zoetermeer (NL); TEEPEN, Tijs Frans, 2628 XK DELFT (NL); STEENBRINK, Stijn Willem Herman Karel, 2628 XK DELFT (NL)
(74) Representative: Peters, Sebastian Martinus
(86) International application number: PCT/NL2006/000457
(87) International publication number: WO 2007/032670

(56) References cited:
- EP-A- 1 505 630
- WO-A-98/54746
- JP-A- 2002 170 767
- JP-A- 2005 347 054

## Description

### BACKGROUND OF THE INVENTION

The present invention relates to a multi particle beam lithography system, a sensor therefore and a method. Such lithography systems, alternatively denoted litho system, generally operate according to a method for transferring a pattern onto the surface of a target, thereby normally using a so called particle beam tool for generating said multitude of charged particle beamlets, which beams may be scanned in one or more directions by means of electronic controls. The multitude of beamlets, also denoted writing beams in the following is to be calibrated by means of a sensor. A method upon which such litho system is commonly based comprises the steps of generating a plurality of writing beams for writing said pattern on said target surface, usually a wafer or a mask. Preferably a writing beam is constituted by an electron beam, emitted by a writing beam source, which may e.g. comprise a cathode, and which may be supplemented with writing beam shaping means such as an array of apertures for converting a beam emitted by said source into a massive plurality of significantly smaller diameter. Also, such known litho system may be provided with collimating means for directing a source beam or a set of generated writing beams into parallel.

In such known method each writing beam is deflected separately at writing said pattern on to said target surface, for interrupting said writing process. This is performed by means of e.g. an array of electrostatic deflectors and beamlet blankers through which the writing beams are passed within the system. Especially in case of a massively multi writing beam system as according to the present invention, such deflectors are provided with so called modulation information by a signalling means. Such part of a lithography system for writing patterns onto wafers or masks, is in the following denoted a beam tool. Such beam tool and such lithography system can in more detail be known from e.g. patent publication WO2004038509 in the name of Applicant.

Further typifying the electron beam lithography under consideration, application thereof is directed to high-resolution purposes. Nowadays applications are capable of imaging patterns with a critical dimension of well below 100 nm feature sizes. Multi beam in this respect in particular relates to so-called massive multi beam system comprising e.g. a number of writing beams in the order of 10000 and higher. In this respect a typical application as currently offered by Applicant comprises 13.000 writing beams. Future developments however are focussed to litho tools comprising a number of beams in the order of 1 million, which systems are intended to utilise a principally same kind of sensor.

Such exposure lithography systems only become commercially viable when at least the position of all of the electron beams is precisely controlled. Due to various circumstances such as manufacturing tolerances and thermal drift, a beam generated in the writing beam tool of a lithography system is however likely to have one or more errors which render it invalid for writing. Such error may be a positioning error, with respect to a designed grid. Such erroneous feature of a beam tool, and therewith of the lithography system, severely affects the quality of the pattern to be written. Yet, the position of an e-beam near the surface to be exposed is required to be known within a distance of a few nanometres and should be able to be calibrated. In known litho systems this knowledge is established by frequent calibration of the beam position.

Apart from above mentioned specific feature, also other features of a writing beam are desired to be known accurately and preferably at multiple instances, and therefore swiftly, during operation of the beam tool, in particular during writing of a wafer, so as to allow an early adaptation of the writing process of a wafer, and to thereby increase the number and chance of correctly written wafers or fields thereof. Known calibration methods commonly comprise at least three steps: a measuring step wherein the position of the electron beam is measured, a calculating step wherein the measured position of the electron beam is compared to the desired position of that beam, and a compensation step wherein the difference between the measured position and the desired position is compensated for, either in the software or in the hardware of the lithography system or said electron beam tool thereof.

Such known measuring or calibration systems hardly pose any inhibit to electron beam lithography tools which are characterised by a relatively low throughput, e.g. only part of a wafer is patterned within one hour, or by a relatively limited number of writing beams as compared to a massively multi beam system. For maskless systems directed at high throughput or with a massively multi beam system as is focussed on by the present invention, the known calibration systems form a limiting factor to the desired high capacity and high throughput, maskless lithography system. With the known methods, a charged particle beam system, e.g. an electron beam based system, needs to be calibrated a large number of times. Where this may be acceptable for a single beam litho system or with a number of beams, this circumstance becomes a problem if 13000 or more beams are to be calibrated in series. In such case the time needed for calibration would far outweigh the time needed for actually treating a field on a wafer. Therefore, so as to increase the throughput of the known litho system, and in accordance with an idea underlying the present invention, the calibration procedure should be speeded up significantly. In the art, several calibration methods for electron beam lithography systems are known. Most use marks residing in either the wafer stage or the wafer or in both. A sensor then performs e.g. the detection or the position of a beam. The sensor being a charged particle sensor, measures the amount of secondary or reflected electrons created by the marker.

One example of a method using charged particle sensors in combination with a plurality of charged particle beams is provided by the LTS-patent 5929454. It discloses a method to detect the position of a plurality of electron beams by using marks positioned on the wafer or stage. The mark is a parallel line pattern and used for several measurements. All measurements are performed by detection of either secondary or reflected electrons from said alignment mark upon scanning. The position of the alignment mark is determined on the basis of the displacement amount of the electron beams and the detection result. Such an electron detector has the advantage of rapidly determining any primary or secondary electrons, however is relatively bulky, i.e. measures within a range of mm, and thereby not suited for litho systems utilising a massive multiplicity of charged particle beams, e.g. 13000 beams or more. In such latter kind of litho systems a typical pitch between beams is in the order of tenths of mm, e.g. typically 150 µm in a present day 13.000 beam system. Apart from the above volume feature of the known sensor and calibrating system, the known system is also relatively expensive, and moreover' not capable of calibrating a massive amount of charged particle beams in qualitative and sufficiently swift manner.

EP 1 505 630 A2 describes a charged particle beam exposure apparatus which exposes a substrate using a plurality of charged particle beams comprises a first measurement member for making the plurality of charged particle beams come incident and measuring a total current value of the charged particle beams, and a second measurement member for making the plurality of charged particle beams come incident and multiplying electrons of each of the incident charged particle beams, thereby measuring a relative value of a current of each of the charged particle beams.

WO 98/54746 describes a scintillating fiducial pattern, and methods of fabricating and using same, on a substrate or a resist/substrate composite, where the scintillating fiducial pattern is used in a spatial referencing scheme. Spatial referencing to the scintillating fiducial grid, or grating, may be implemented with a delay-locked loop, which locks the phase of a signal from the scintillating grid, or grating, to the phase of a known signal.

JP 2002-170767 describes a method of evaluating beam, etc., by which the intensity distribution of a beam can be evaluated. A pinhole is provided in the central part of one visual field of a reticle. A hole plate is made of copper, etc., and has a hole of about 10 µm square in its central part. A monitor is arranged between a photomultiplier and an illuminating beam deflector. After the beam passes through the hole plate, the beam comes into collision with a scintillator and emits light. The light is converted into electric signals by means of the photomultiplier and the signals are inputted to the monitor. The signals are displayed on the monitor.

In a massively multi-electron-beam lithography system also other problems arise, in that e.g. adjacent beams should not influence the accuracy of the position detection. Also, it is not clear with the known method and system how to perform both data acquisition and data processing within a reasonable limit of time for all of the massive amount of writing beams, i.e. within a period of time which is much less than the period required for writing a wafer. The latter problem is especially significant because of an additional requirement, at least strongly desired feature common in the art, of frequent calibration of the entire beam tool during the process of writing a wafer, so as to monitor and timely compensate for e.g. said earlier indicated dynamic drift of writing beams. Such manner of proceed prevents undue loss of treated wafers, i.e. of performed work by an expensive machine.

### SUMMARY OF THE INVENTION

The present invention solves the problem posed, of swiftly detecting charged particle beam features of a massive multiplicity of beams by converting the charged particle beams into light beams, thereby using a converter element such as a fluorescent screen or a doped YAG (yttrium aluminum garnet) material, subsequently detecting the light beams by means of an array of light sensitive detectors such as diodes, CCD or CMOS devices, alternatively denoted by using a camera, and subsequently electronically reading out the signals of said camera, i.e. of the cells or detectors thereof. In an embodiment the signals of said camera, i.e. of the cells or detectors thereof are read out in a single operation, either successively, preferably at a high clock rate, or in parallel, i.e. simultaneously. The signals are read out after a predetermined period of time of exposure and are used for determining values for one or more beam properties by means of an automated electronic calculator. The calculated property values are used for calibrating all or a number of said writing beams. Such modification may either be performed by electronically modifying pattern data, thereby allowing for the actual beam properties, and/or by influencing the beams themselves. According to a preferred embodiment, calibration is solely performed in software by modifying said pattern data.

Such light sensitive detectors generally have a rather poor performance in that the response of light sensitive sensors such as a CCD (charge coupled device) is slow. It is the merit of the present invention however to have conceived that despite such slow response, the surprising composition of the sensor according to the invention, achieves a relatively very fast sensor as compared to utilising one or a number of known electron beam detectors. In this respect advantageous use is made from the capability of reading out a large number of light sensitive detectors, alternatively denoted cells, in a single operation, either successively, preferably at a high clock rate, or simultaneously. In the sensor according to the invention all of the light sensitive detectors are preferably read out simultaneously. Moreover, the present sensor structure, in particular by the array of light detectors, enables a very small pitch of a multiplicity of beams to be measured without the necessity of unduly large structural measures in the region of the stage part of a litho system.

The latter feature of measuring light signals, i.e. photons is known per se from the field of digital cameras, where also a multiplicity of light detectors is electronically read out at least virtually simultaneously. By utilising such a kind of array of detectors, the beam sensor according to the invention may as a further advantage thereof, be realised in a very cost-effective manner. The purpose of measurements according to the present invention is to determine the positioning of writing beams and to determine if they are within specification. Measuring is performed under either one condition where a writing beam is continuous on, or where such beam is set on, on a timed basis. Both types of measuring may be performed in combination for determining a value for different beam properties as will be set out in the following. At measuring according to the invention, so-called point spread functions are determined for each respective "writing beam. Rise and fall times of a beam are not measured directly, however are derived from such function.

It is remarked that also the idea of converting charged particle beams into light beams is known per se, in this case however, from yet another technological field, namely from the field of electron microscopes. In this field of technology, directed to accuracy rather than to speediness, it is known per se to convert an electron beam into light using a converter element. Often such converter element is embodied by a so-called YAG (yttrium aluminum garnet) screen, however could e.g. also be a fluorescent screen. The photons subsequently realised by such conversion are received by a so-called photomultiplier for an amplified electric signal that is subsequently to be attained. Such photon-electric conversion is performed by a single converter cell.

In the latter respect, the present invention might also be characterised as having solved the problem posed by the fact that a writing beam size is notionally smaller than the resolution of known sensors. Also at scanning over a mark the known detector is considerably larger than the pitch between two beams of the litho system currently improved: with the known detector the signals of a plurality of writing beams would overlap. As to the further problem and current solution with respect to size of the known detector, it is to be noticed that the scanning detector system according to the invention may, for the said massive multiplicity of beams, typically be applied within a pitch of 150 [mu]tn (micrometer). In this respect, the diameter of a writing beam typically is smaller than 45 nm (nanometer). In contrast, the present invention enables and is directed to a method, system and sensor, wherein the spot size of a charged particle beam is smaller than the resolution of the converter element. This is realised by utilising measured intensity values of a light beam for determining beam properties, in particular in combination with a knife edge, as will be exemplified in the description of the figures. Such determination is performed on the basis of a plurality of signals resulting from a stepping proceed of a charged particle beam which is scanned in one direction at a time over a mark or blocking element.

Furthermore, the light conversion in the manner according to the invention allows the use of relatively cheap, light sensitive detectors, i.e. arrays thereof, such as CCD (charged coupled devices) and CMOS (complimentary metal-oxide semiconductors) devices. Such light detectors convert light into intensity counts, often electron based, and have the advantage that they are widely available, technically well known and cost effective. They come in rather compact form, meaning that a very high pixel resolution can be obtained. In other words, a massive amount of charged particle beams, after conversion into light beams, can be sensed at the same time. In line with this advantage, such individual light or pixel sensors can be read out at least virtually simultaneously, that is in a single operation, either successively, preferably at a high clock rate, or simultaneously. An example of this feature is set by reference to the application of such sensors in digital cameras. By virtue of these above said features of at least virtually simultaneously reading out and conversion of charged particles into light, a relatively slow light sensor as compared to above mentioned known charged particle sensor, can be used to still make the calibration of a massively multi charged particle beam tool both significantly faster and cheaper than at use of charged particle sensors, all without undue requirement of space, and all enabling a for massive multi-beam systems required resolution. The new sensor, calibration method and lithography system enables the calibration of a massive multi charged particle beam tool in a highly economic manner, despite a seemingly complexity due to the number of structuring elements of the new sensor and due to the physical conversion method applied therein.

In a sensor according to the invention an accumulated charge or intensity at each cell is at a predetermined time read out individually. In a CCD device, a charge of a light sensitive element thereof induced by the impingement of light thereon, is normally transported across the chip and read at one corner of an array. An analog-to-digital converter turns each pixel's value into a digital value. In CMOS devices, commonly there are several transistors at each pixel that amplify and move such charge, using wiring for transporting the charge to a read out part of the device.

A rather favourable feature of the present invention over the known sensors for charged particle beams tools is that rather than using scattered or secondary electrons, the new sensor can directly measure one or more writing beams, i.e. in the sense that the sensor can directly be located in the projection of a writing beam, i.e. in the surface area of a wafer, which brings about significant spatial advantages in the design of the beam tool.

A further advantage of the system according to the invention is that despite of the economic nature of it, rather than position only, a multiplicity of features of the beam tool is determined during a single measurement thereof, thus adding up to the efficiency of both the new sensor, and the beam tool to be calibrated. Such features include beam position, beam spot size and beam current, as well as functioning a blanking element common to such beam tools, and timing delay thereof at functioning. The invention further relates to partly blocking a beam directed to the sensor by means of a blocking element provided with a knife edge, thereby enabling measurement of a maximum dimension of a spot created by said beam on the sensor in a favourable and effective manner. The beam is scanned, in fact stepped relative to the sensor and thereby relative to said knife edge while optionally being switched on and off at predetermined intervals of time, thereby creating a limited amount of data that can favourably be used for deducting beam properties by using line fitting software. Such stepping can according to the invention be repeated for one or more times, preferably each time at increased intervals of time. The beam properties are determined on the basis of a set of signals obtained while mutually shifting the beam blocking element, i.e. mark and the charged particle beam, thereby using a blocking element included at a known position relative to the converter in said sensor.

A beam is preferably stepped over such above mentioned knife edged blocker or mark in at least three directions, thereby enabling ellipse fitting. A mark is thereto preferably embodied hexagonal, thereby favourably optimising sensor time by enabling stepped scanning and detection both in back and forth direction of a beam sweep in one direction. Such mark is according to the invention technically and economically favourably included at a known position relative to the sensor, in particular by structurally integrating it therewith, i.e. mounting it on top, i.e. to the surface of the sensor.

For some measurements, i.e. at least for measuring writing beam current however, a beam is directed at a location on said sensor surface where it is not intercepted by the said beam blocking mark. Adaptation of the system on the bases of such automatically deducted beam property values is performed by at least one of electronically modifying electronic data, in particular control data, for a pattern to be imaged by said charged particle beam system, modifying line width, and electronically influencing a position modifying means of said beam system, for modifying the position of one or more charged particle beams, in particular by introducing a time delay. Especially, however not exclusively in the case of application of a CMOS device, in the sensor according to the invention, a light beam modificator such as a fiber array or a lens system may be integrated between the converter and the receptor for optically modifying, i.e. increasing or decreasing the image of an emitted light beam, thereby optimising the internally generated light beam for the light sensitive receptor.

In a calibrating system according to the invention, values for the above features are derived from a multiple beam sensor by a calculating unit. Correction signals generated by this unit are according to the invention either used for influencing the beam tool, or for influencing an image pattern stored in a computer means, which pattern in fact forms an instruction basis for the beam tool.

Due to the size of the new sensor, it can be and is according to the invention placed at multiple positions in a beam tool. In this manner calibration frequency is increased without wasting valuable operating time by significant movement of the target, i.e. wafer, in particular a sensor associated therewith, for correct positioning thereof relative to the beam tool in use.

In a further elaboration of the method and lithography system according to the invention, the charged particle beam system, at least the beam generating part thereof is provided with an optical sensor. The detector for detecting beam properties, in particular the pattern of blocking elements thereon is utilised for optically- detecting the position of said system relative to an independently moveable stage for holding a target surface and comprising said detector. The various aspects and features described and shown in the specification can be applied, individually, wherever possible. These individual aspects, in particular the aspects and features described in the attached dependent claims, can be made subject of divisional patent applications.

### BRIEF DESCRIPTION OF THE DRAWINGS

The invention will be elucidated on the basis of an exemplary embodiment of a maskless lithography system according to the current invention shown in the attached drawings, in which:
Figure 1 is a schematic representation of a calibration part of a lithography system comprising a sensor according to the invention;
Figure 2 is a schematic representation of an embodiment of a sensor according to the invention, for determining characteristics of a writing beam for a lithography system;
Figure 3 is a schematic representation of a further embodiment of a sensor for determining characteristics of a writing beam for a lithography system;
Figure 4 is a schematic top view of the sensor embodiment according to figure 3 ; Figure 5 is an illustration of a signal derived from the sensors according figures 3 and 4;
Figure 6 in a top view represents yet an alternative and currently preferred embodiment of a regularly shaped six-angular mark to be included in a sensor;
Figure 7 provides the a signal as derived from a spot crossing a mark, e.g. as in figure 6, used for determining spot size and position in the direction of relative mutual movement between beam spot and mark, i.e. sensor;
Figure 8 schematically represents a top view of a wafer and wafer chuck, and part of the fields on said wafer, to be processed by a lithography system, improved by having the present sensor located at a plurality of strategically selected locations outside the wafer;
Figure 9 represents a graphical relation between measurement signal according to the invention and a typical Gaussian distribution of Amperes per meter (A/m) versus size X of said spot; and
Figures 10 and 11 schematically illustrate a so- called timed measurement according to the invention, showing desired positions of beam "on" and "off" relative to a knife edge in figure 10, and the subsequent timings thereof for one beam as well as a time delay used thereby in figure 11.

### DETAILED DESCRIPTION OF THE DRAWINGS

The present invention provides a design for a lithography system fitted with an electron beam alignment sensor suitable for transferring patterns at contemporary requirements, e.g. of 45 nm and smaller at a speed of 10 wafers or more per hour. The invention includes a new sensor for detecting characteristics of projected charged particle beams such as electron beams within a litho system known per se, e.g. from WO04/038509 in the name of Applicant or within a multi beam inspection tool. The new sensor comprises a scintillator, here in the form of a so- called YAG (yttrium aluminum garnet) material, combined with a CCD (charge coupled device), alternatively denoted camera. The YAG screen applied here is a Ce (Cerium) doped garnet. Features of a charged particle beam are derived by automated, electronic measuring and calculating parts on the basis of a measurement of a signal generated in such a sensor at moving a charged particle beam relative to it. In the present system, normally a writing beam will be moved relative to the sensor by realising a stepping movement of it within a writing beam tool, typically over a distance around the range from a a few hundred nm to 2,5 µm. Stepping is in the beam tool performed by influencing an electric field on two deflectors, or on one deflector and a wafer stage. A beam can herewith be scanned in e.g. three different directions. During such scan, a beam blocking part provided with a so-called knife-edge is maintained at a known position in between the beam-generating tool of the system and the said sensor. In a favourable embodiment of the new sensor, the blocking means is fixed to the surface of the sensor. The known position of said blocking part is attained by at least one and preferably a combination of all within a set of measures comprising good manufacturing practice for accurate positioning, calibration of the system, i.e. performing measurements within the machine at installing it and preferably at regular intervals that are significantly larger than at measuring during writing operation of a wafer and, thirdly, by optically determining the sensor and wafer position relative to the beam tool. With respect to the latter, a particular shape of the blocking part of the sensor is favourably utilised in the present invention. With a known, in casu optically detectable mark on a wafer, and said marks on the sensor, the position of the wafer with respect to the sensor is known using an optical measuring system known per se. After also having determined the position of a number of writing beams with respect to the sensor according to the invention in a manner as will be explained in the following, the position of the writing beams relative to the wafer is known. A further measure for enhancement of accuracy at measuring, includes that said blocking part is made as small as possible and that it is included in the sensor on a layer of low coefficient of thermal expansion such as glass, e.g. "zero dur" glass. With the accuracy attained in accordance with the invention, and with the known position of writing beam relative to the sensor, in a preferred embodiment of the invention each writing beam is positioned over a single, related mark on the sensor.

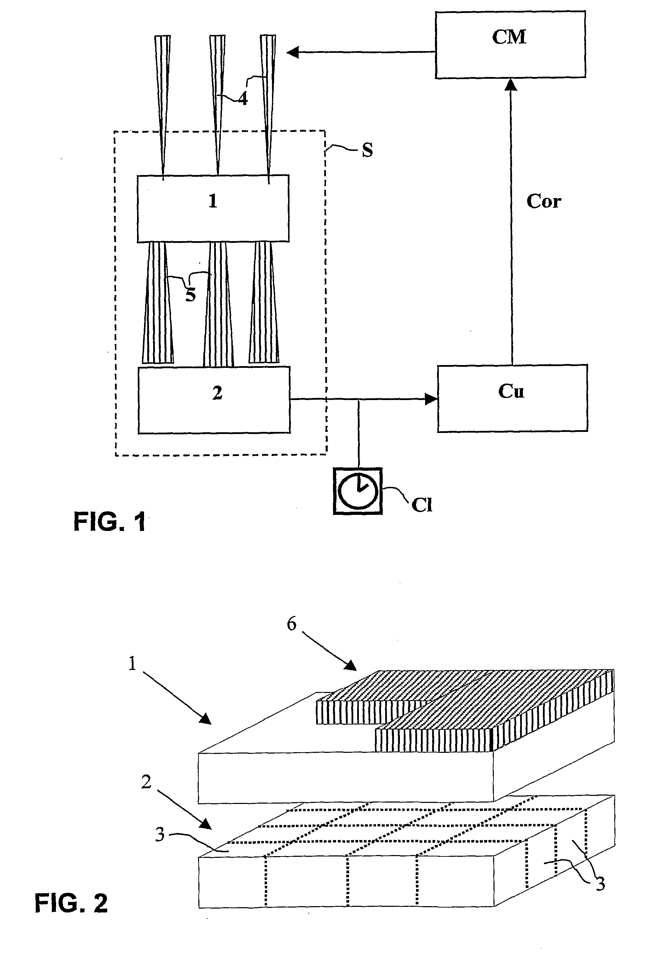

With the system, sensor and method according to the invention a framework is provided for detecting the functioning of a beam tool blanker feature known per se, any time delay thereof, as well as position, current and spot size of all of the beams produced by said beam tool. These features can now, for all beams of a massively multi- beam tool, be detected, within a relatively short period of time, e.g. within a minute. As will be elucidated in the following, time delay, and positioning error of a writing beam may be measured by different measuring methods, with and without using a knife-edge respectively. Time delay in this respect is the delay between an instant of instruction "on" or "off" to the beam tool and the effect thereof at wafer, in casu sensor level. Figure 1 illustrates a system part and method in which a sensor S according to the present invention is embedded. Upon impingement of a charged particle beam 4 on sensor S, in particular on converter element 1 thereof, a light beam 5 is emitted by the converter 1, which is received by a camera 2, i.e. at least by a photon receptor 2. After a predetermined time controlled by an electronic system clock Cl, the photon receptor is, i.e. the individual cells are read out in a conventional manner and data is provided to a calculating unit Cu in the system. The calculating unit determines offset from predetermined values of beam features such as position and magnitude, and provides correction values Cor to a control means CM for controlling the charged particle beam tool to be calibrated. This means that either or both of memory stored data for generating a pattern and the beam tool is automatically adapted by said control means. Thus, for measurement of properties of charged particle beams such as electron beams in a multi-beam charged particle system, in a preferred embodiment, a so-called knife edge scan with writing beam blocking marks 6 covering the converter, in casu YAG screen, is performed, the pattern resulting from such scan is imaged from said YAG screen on a camera, preferably a CCD camera.

Figures 2, 3 and 4 schematically depict embodiments in accordance with the present invention. Besides said beam current, and the X- and Y-position of a beam, a capability of detecting the size of an individual charged particle beam in e.g. x and <'> y-direction is made possible. Converting means 1 are placed on top of photon- receptive means 2. A mark 6 comprising a knife edge, in figure 2 referred to as a first exemplary mark 6, is preferably ultimately closely positioned before said converter means 1 in the optical pathway of the charged particle beam 4. The mark 6 can be and is most preferably, as here depicted positioned directly on top of the converting means 1. However said mark 6 may, still in accordance with the invention, alternatively be located at a known location, further away from said converting means 1, for instance on a separate carrier plate transparent for charged particles. In a preferred embodiment, the YAG screen is also included on such carrier when it is incorporated fixed on top of the sensor, thereby allowing a desired ultimate reduction of the thickness of the beam blocking material. The receptive means 2 is in this example composed of a plurality, i.e. a set of grid cells 3 per beam to be calibrated, in casu sixteen cells 3, arranged as a frame of square configuration conforming to preferred embodiment. Yet, in accordance with the basic principle as conceived by the invention, such a frame can also be embodied by a single cell 3.

Though for sake of clarity not depicted in e.g. figure 2, in the pathway of an electron beam in the sensor, the latter further comprises a thin layer for blocking background light, e.g. an aluminum layer of a thickness within the range of 30 to 80 nm, included between a mark 6 or charged particle blocking layer of the sensors and the converter. Such background light blocking layer enhances quality of the sensor by preventing background light from interfering with the light generated by the converter, i.e. with a writing beam.

The beam blocking layer or mark 6 should according to the invention be thick enough to sufficiently block an incoming charged particle beam, while on the other hand should be thin enough to minimise defocus and edge roughness effects. Thus a mark 6 is composed of a heavy metal, preferably of a tungsten alike material, in a thickness generally within the range of 50 to 500 nm.

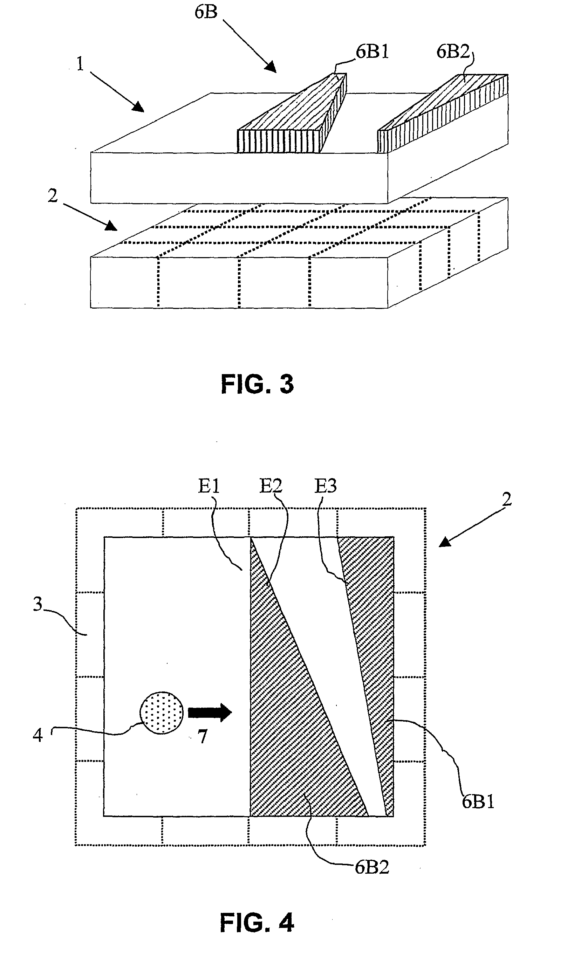

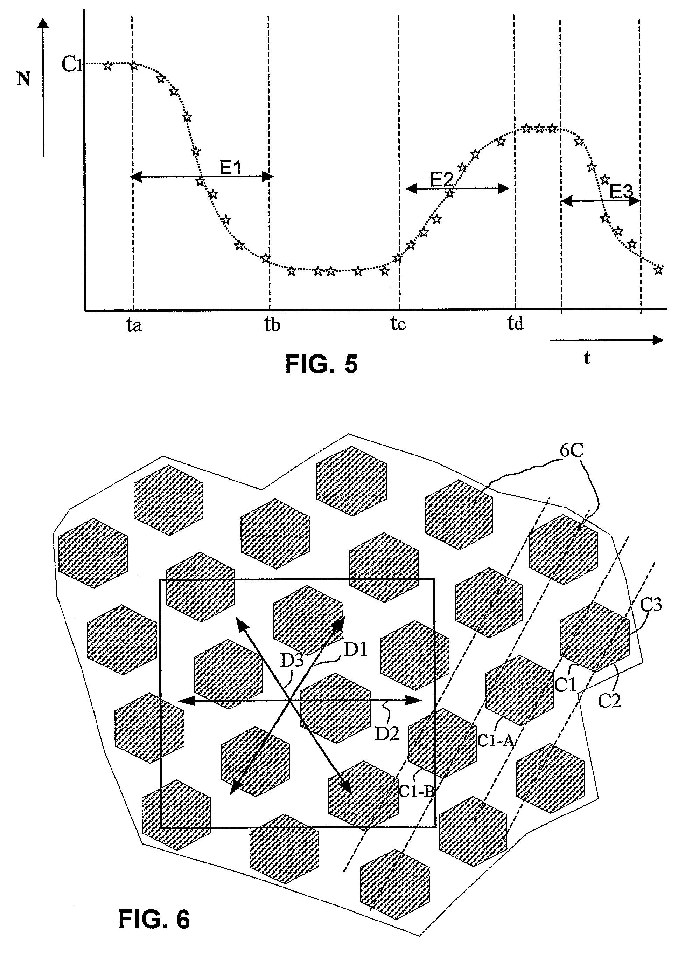

The mark 6 in the embodiment according to figures 3 and 4 is composed of two spatially separated parts 6B1 and 6B2, and shows, in the direction 7 of scanning, a first perpendicularly to said direction 7 oriented knife edge E1, and two subsequent knife edges E2 and E3 , each oriented under a different sharp angle with said direction as taken in top view. By the presence of at least one such sharp angle, only one direction 7 of scanning is required for measuring spot position. This measurement is improved without significant increase in required scanning time, by including two sharp edges E2 and E3, each oriented under a different angle. A further sensor embodiment including a mark 6C, and requiring more scanning time, however providing a relatively superior signal quality is disclosed along figure 6.

A potential result of the scan performed in perpendicular direction over an edge of exemplary mark 6B depicted in Figure 4 is drawn in Figure 5, which represents a detected number of counts CI after a number of steps t. Before reaching the left edge E1 of said exemplary mark 6, the photon-receptive means 2 counts the number of photons in the entire beam, i.e. a constant number of photons CI, is detected per unit of time. When the right side of the charged particle beam 4 hits the left edge E1 of the mark 6 at step tA while moving towards the right into direction 7, fewer electrons will be converted thus fewer photons will be detected by the photon-receptive means 2. By comparing the expected step of reaching said left edge A, the actual position of the charged particle beam 4 in said first direction is in accordance with the invention determined. While moving said charged particle beam 4 further in said direction 7, fewer and fewer photons are detected. Eventually at step tB, the number of detected photons reaches a minimum value. The charged particle beam 4 is now entirely blocked by the mark 6B. The length of the scan corresponding to the steps between tB and tA is a measure for the size of the beam 4 in said first direction 7. The step where the intensity is at the middle between high and low level at an edge E1-E3 is taken as the beam position. A following edge E2 that the beam will pass while moving in the first direction 7 is not oriented perpendicular to said first direction 7. Due to the orientation of this second edge E2, the writing beam 4 will reach said edge E2 at a different step tC depending on its position in a the direction perpendicular to said first direction in the plane of the sensor, i.e. as taken in top view. Continuing the movement in the first direction 7, more and more photons are detected by the photon-receptive means 2. In the depicted embodiment a position measurement in multiple directions is thus enabled by scanning in a single direction. A possible disadvantage of this detector and method may however be constituted by the amount of data that is required to measure the writing beam properties. This current disadvantage however is anticipated to disappear with the evolution of computing technology.

So as to allow for sufficient scans to average out so-called measuring noise in a method and system according to the invention, a fast camera with binning capabilities is utilised. A predetermined minimum number of scans is performed so as to attain a desired accuracy for determining the beam position within the requirement. With the present type of detector it is not needed that there is no dead area, both a CCD and a CMOS cameras are equally- feasible. Actual application of either of the two is based on accuracy of available camera, binning capability and, very important, readout speed and possible frames per second.

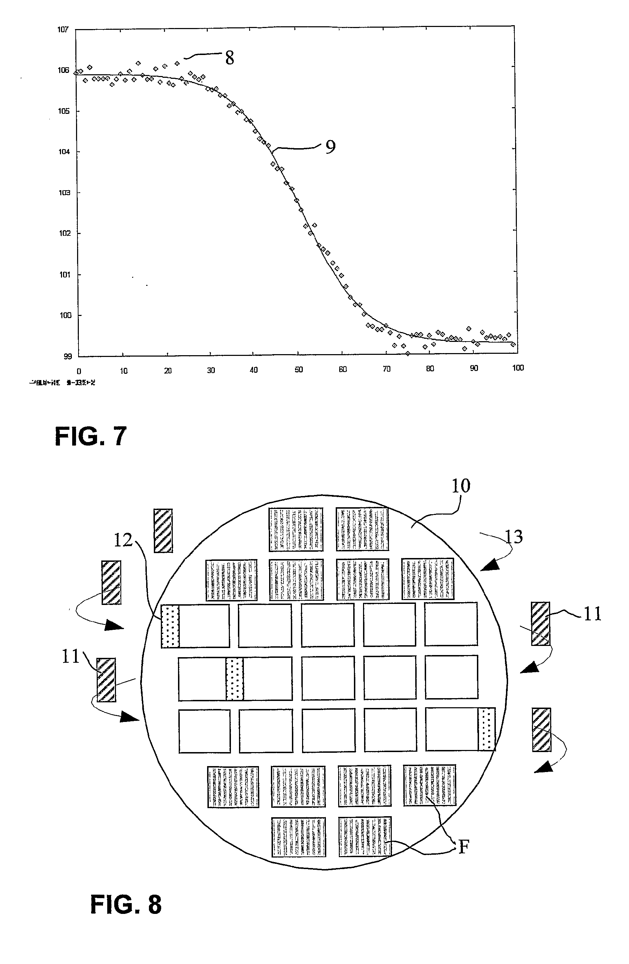

At using a knife edge scan and an appropriate mark 6, not only the position and the current of a single writing beam is determined, but also the spot size in two or three directions as in accordance with a preferred embodiment. By scanning over the mark 6B the measurement signal will be as in figure 5, or as in figure 7 at applying mark 6C of figure 6. From the rise and fall of a signal, both the position and the sigma of the Gaussian beam are obtained. The beam current is obtained from the maximum signal. A possible and currently preferred mark 6 is shown in figure 6. With the knife-edge scans, all of spot position, spot size, spot current, and timing delay and functioning of blanker are in accordance with the invention may be measured as major properties of individual writing beams.

One property that according to an elaboration of the invention may be measured in an advantageous way is the beam position relative to the blanking information grid. In other words, the real beam position that corresponds to a blanking signal. Detected displacement of the writing beam is according to yet further work out split up in the real physical displacement of the beam and the relative time delay of a blanking signal with respect to the internal clock C1 in a lithography system according to the invention, in which the charged particle beam is turned on and off by a blanker means acting upon an electronic (blanking) signal. At calibrating a single beam, both contributions are corrected for. The easiest way to calibrate said position and timing error is to measure the total displacement in one time. In accordance with a further aspect of the invention, the total of displacement is measured in a single instant. This is performed by blanking the writing beam. A writing beam 4 is scanned over the sensor S and switched on when it is at a predetermined lay-out position. The beam 4 is switched on for a pre-defined period of time. The for measurement required number of electrons is obtained by performing multiple scans over the detector 6. Since in this approach of measuring, which advantageously reduces noise, the spot of a writing beam 4 on the sensor S, is obtained by blanking the beam 4 within the beam tool producing the beam 4, both the physical displacement and the time delay is measured. Advantageously in a further kind of measuring, the beam 4 is switched on and off for a multiplicity of times at different positions. It may be clear that by departing from the preceding, various embodiments within the scope of the current invention may further be developed. One example of such is provided by figure 6, which schematically shows the top surface of a sensor in accordance with the invention, showing a multiplicity of equally oriented blocking elements 6, here denoted 6C. The blocking elements include at least three sharp edges C1, C2, C3 mutually oriented under an angle of 120 degrees. In this manner according to the invention, the measured spot properties can be fitted with an ellipse shape. Alternatively angles of 60 degrees could be used, forming a regular triangle. In this way scanning may be performed in at least three directions as is preferred. In a further elaboration of the invention however, such blocking element 6C is provided with angles larger than 90 degrees. With such a measure, in accordance with a concept underlying the invention, the chance of a projected focused beam entirely being intercepted by the mark is optimised. Alternatively posed, the chance of a beam spot being scanned over an edge part of the mark, thereby disrupting the measured signal, is minimised. Secondly, with an angle larger than 90 degrees, knifeedge scans may still be performed in more than two directions, enhancing the capability of determining spot shape and size. The most preferred mark is composed as a regular six angular shape, comprising two sets of such sharp edges C1, C2, C3. In this manner both of the earlier mentioned features are integrated in the mark, while moreover the mark provides the possibility to collect a signal both at moving back and forth.

In a further elaboration of the preferred sensor, a plurality of the preferred hexagon shapes is included on the surface of a sensor for each beam to be calibrated. In this way both a chance of a rightly positioned scan as well as the quality of measurement by having multiple, independent sharp edges within one direction is increased. In a method for utilising such a kind of sensor, scanning is performed preferably back and forth in multiple directions D1 to D3 as indicated in the drawing, each direction D1 to D3 being perpendicular to one of said sharp edges C1 to C3. All of the marks on the surface of the sensor have the same spatial orientation. They are preferably arranged such that at scanning a charged particle beam in one particular direction perpendicular to one of the edges of a mark, the scanned beam will encounter a correspondingly oriented edge irrespective of its position with respect to the sensor. In other words, correspondingly oriented edges of different marks join to each other, while being dislocated. In this manner a scanned beam will in the neighbourhood of the position where it was switched on, always encounter a knife edge oriented in the same direction, i.e. in near vicinity marks, i.e the knife edges thereof adjoin in the in the parallel direction. Such scan D1, D2 or D3 of a beam 4 may take place over a width on said target surface area of e.g. about 2,5 µm. Otherwise posed, the mutual position of sensor, i.e. the marks thereon and beam tool is such that at scanning in one direction the chance of encountering a knife edge is one. Favourably, the knife edges are measured a number of times the largest expected spot width, e.g. are measured by a factor within the range of 1 to 6 times said width or diameter in case of an expected round spot shape. With respect to number of marks per writing beam, a ratio of a plurality of marks per writing beam may be utilised, thus enhancing the chance of swiftly encountering a knife edge within the scanning range at scanning a charged particle beam. However, an even more swift result is according to the invention attained in an embodiment where a ratio of one mark per beam is applied, which ratio is a. o. advantageous in that the absolute position of a beam can easily be determined. A typical width of a knife-edge C1-C3 in the present example with only 13000 writing beamlets, having a typical spot size of 45 nm, would be around 270 nm, in the current example raised to 300 nm. Figure 7, in a manner corresponding to that of figure 5, by bullets 8 provides an exemplary set of measurement data of at least one scan over a plurality of sharp edges in one direction, e.g. a plurality of edges C1, and a fit trace 9 mathematically deducted from said set of measuring data. Since the present sensor for measuring a massive multiplicity of writing beams is devised rather slow, the measuring frequency is low as compared to utilised at microscopy. Where in the latter case measuring is performed in the order of kHz rather than in the order of Hz as in the present case, alternatively denoted, where a virtually continuous signal is attained, the present measuring system departs from the underlying insight that a limited number of measuring data, e.g. 6 readings per second, may be sufficient if a fit is performed, as well as from the insight that a fit, rather than a virtually actual trace is sufficient for the purpose of deriving the above described beam tool characteristics. In the latter respect, e.g. the slope of fit trace 9 is an indication of the spot size in the scanning direction. With the presently devised sensor, detection of feature values for a massive multiplicity of writing beams to be calibrated will in most cases be significantly faster than at repositioning the known, relatively fast photocell and knife edge sensor, as known from microscopy, from beam to beam as would in the use thereof be required for a multi beam tool. From a signal thus attained, apart from e.g. timing delay information, also rise and fall time is deducted, and the beam current of a writing beam is derived.

It goes without saying that various other shapes than here above mentioned may be devised for realising sharp edge scans in even more than three, i.e. in a multitude of directions. Three directions of scanning is however considered a reasonable amount of scanning direction for economically rather precisely determining e.g. spot size and shape.

Thus, in fact measuring is performed by stepping over the sensor, rather than scanning. At stepping,' a beam is (switched) on when it is relative to the sensor positioned at its expected location. From the deviation of the derived signal with regard to the expected signal, the spot position error and timing error of the blanker of the beam tool is derived. A beam is further according to the invention switched on when the spot created by it on the sensor is not over a part that is blocked by a mark.

Figure 8 schematically provides a top view of a wafer as included in a litho system according to the invention. In this view various fields F have been omitted from the drawing for sake of simplicity of drawing. The drawing illustrates the possibility, due to the strongly reduced costs of a sensor according to the invention, to include a plurality of sensors 11 in close vicinity of a wafer position 10 within a litho system according to the invention. E.g. one sensor may be located at a starting position, e.g. at the left and top side of the wafer position 10 as drawn in the example of figure 12. Subsequent sensors are, in terms of number of fields F, distributed at regular distances over a track 13 of a particle beam projector 12 over a wafer position 10. The track 13 is indicated only partly by a number of arrows. The sensors are included in the litho system close vicinity of a wafer 10, so as to minimise travel of the beam tool. In this schematic example, sensors 11 are included after every 5 or 6 fields F of a wafer. After the last group of fields F is treated by the beam tool, a shift is made to the initial position, here at the left top side of the drawing, while the wafer is being unloaded from the system.

As to the different types of measuring enabled by the sensor and performed in a method according to the invention, it is remarked that for current measurement of a writing beam, the beams will be positioned above a YAG area of the detector and with a continuous beam-on measurement the current are measured. A plurality of measurements, in the order of 10-20 is performed and of these the average current is determined. With the sensor according to the invention this can be done in less than 1 second for all 13000 beams. The current variation from beam to beam is determined from the data thus generated. The required time for such current measurement, with 1 nA, typically is 160 µs. However typically within 15 µs a CCD well will be filled. Thus, a number of measurements is performed, typically within a range around 10-15 will be performed, and of these the average current will be determined. This can be done in less than 1 second for all beams. The current variation from beam to beam is also determined from the data. Based on the current measurement the beam tool system determines if the average current of the valid beams is within specification. If not, either the settings of the source are changed until a valid measurement has been reached, or when that is not possible, the system determines if the current is expected to stay constant during the forthcoming exposure or if a source replacement is required. Pulse duration variation is measured by performing a timed switching current measurement with pre- determined on/off ratios of a projected beam.

As already indicated in the above, with respect to beam position, DC (direct current) phase noise and point spread function of the generally Gaussian distributed spot intensity, including rise and fall time, two alternative measurements have been developed, which will in the following be discussed somewhat further in detail: one with the beam continuously on, and one with the beam on only on timed intervals. With the beam continuously on, the beam position and the point spread function (PSF) of the Gaussian distribution in one direction can be determined. With the timed scan, the scanned PSF, including rise or fall time and the shift in scanned e-beam position is measured, including DC phase noise.

For the continuous measurement a stepped deflection is performed with the beam on. The position of the knife-edge with respect to the deflector voltage, a measure for the beam position change with respect to its nominal position, is determined. If the exact position of the edge is now known with respect to the wafer stage position, the exact beam position can be determined. One measurement trace represents the integrated beam spot. Departing from a Gaussian beam profile, the trace thus represents the integral of the Gauss function. This is used to fit the measurement result with a cumulative Gaussian. From the fitted Gauss a PSF is determined. In case it is determined that the spot is not shaped as a Gauss, a more accurate one-time determination of the spot shape is performed. The measurement results are then amongst others fitted with the previously measured spot shape.

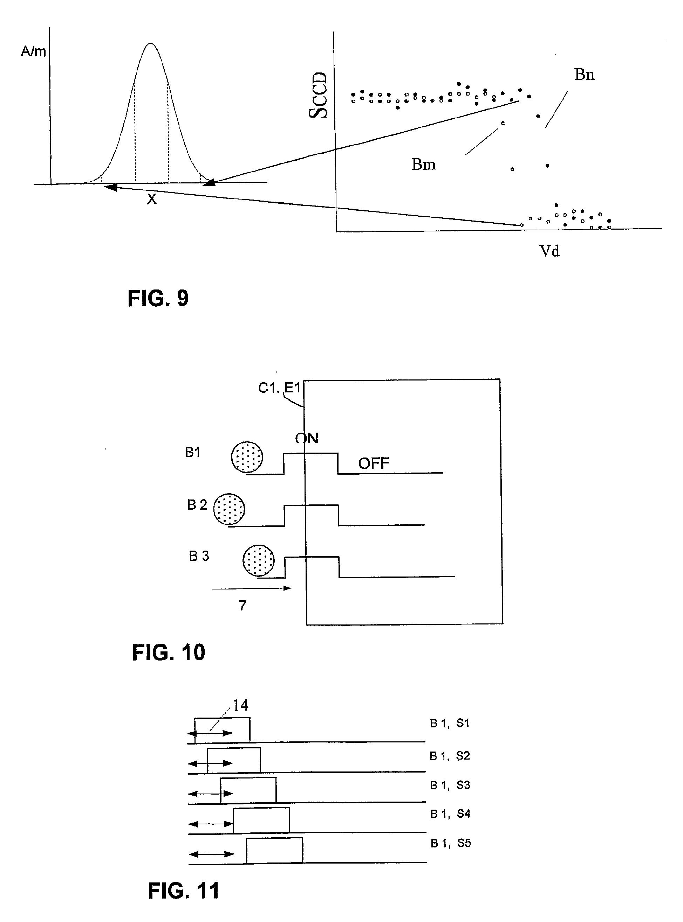

Figure 9, i.e. the left hand side graph therein, provides an illustration of the here above discussed continuous measurement and Gaussian distribution of intensity A/m of a spot, alternatively denoted spot shape, as created by a beam 4 on a sensor S according to the invention, or on another target such as a wafer. The right hand side graph provides CCD signal read outs Seed against deflection of a beam, measured in applied deflection voltages Vd in the writing beam tool for two writing beams Bm and Bn. Each measurement as reflected on the right side corresponds to an area under the Gauss, integrated from infinity to a certain point on the spot, which represents the position of the knife edge. It can be thus be seen that the trace in the right side figure, which is derived from the measurement data therein, represents an integrated Gauss. In the present example with 13000 writing beams in the beam tool, the deflection range for determining the position of a beam is set at 300 nm, while the knife edge is placed at a nominal origin position. In this manner it is ensured that a beam, with a displacement of maximum around 100 nm, crosses the relevant knife-edge. - For setting the step size of a measurement it is departed from a minimum number of points required for fitting a Gauss curve. The amount of time needed for measurement of each point is determined by the frame read out speed, which sets the time for each single scan.

Along Figures 10 and 11, as an alternative to the preceding, and as a preferred method of measuring, a timed measurement is illustrated. With a timed measurement method the number of points per single scan is reduced significantly. Figure 10 in this respect illustrates this so-called timed knife edge principle with figurative representation of a knife edge and the required "on" position of a couple of respective writing beams B1 to B3. A "positioning" of a writing beam "ON" is achieved by using a time delay per channel, which is available from the previous exposure and which is provided within the system, preferably by the beam tool, in particular from the control unit thereof. This time delay is in figure 11 represented by the double-sided arrows 14, while the blocks show the period of time where a beam is set to "on" mode. The latter is performed by the blanking system of the beam tool, and implies the presence of a beam spot on the sensor. For a writing beam measurement it may be assumed that the beam is not shifted drastically (less than 10 nm with respect to previous measurement), so a time delay per channel for the previous exposure can be used. The measurement result thus is the position shift B1, S1 - B1, S5 of the scanning writing beam B1 with respect to the previous measurement, due to DC phase beam position change. Also the PSF measured with this method includes the rise or fall time. To perform this measurement and obtain at least five data points around the knife-edge, different scans are performed. The width of the beam-on sequence is such that it only covers a single knife-edge. The displacement of the beam-on position is obtained either in the data system or by adjusting the mean deflection voltage.

Apart from the preceding the same invention is in an alternative description defined along the following lines. In this respect it can be stated that the invention relates to a sensor for calibrating the positions and validity of a plurality of charged particle beams with respect to each other. Said apparatus or beam tool comprises a set of charged particle detectors having a known relative position with regard to each other. Said charged particle detector is provided with a detection area comprising a limited number of grid cells. Said limited number of grid cells equals at least four. The charged particle detectors are rigidly attached to each other. The validity of a writing beam is determined by the control unit of the system according to the invention by determining whether, with respect to a predetermined set of properties to be measured by a writing beam sensor, all of the determined values of the set, i.e. each value of each respective property, fall within a predetermined range defined for each respective property. The apparatus furthermore comprising a calculation unit: to determine the difference between the design positions of said plurality of charged particle beams and positions of said plurality of charged particle beams detected by said set of charged particle detectors using said known relative position between said set of charged particle detectors, and to calculate correction values to correct for said determined difference. The apparatus is also adapted for adaptation of an individual image pattern of a single beam, based on calculations of said calculation unit. All the same the apparatus is adapted to adapt CD (critical distance) control in the same manner. All type of the indicated adaptations may be implemented in the same apparatus if desired.

Said position correction means of the apparatus, also may comprise a plurality of electrostatic deflectors. Said charged particle detector may comprise: converting means to convert a detected charged particle in at least one photon; photon-receptive means located behind said converting means along the optical pathway to detect said at least one photon created by said converting means.

Said converting means may comprise a plate provided with a fluorescent layer to perform said conversion and said fluorescent plate may comprise a YAG crystal. The photon-receptive means may comprise a limited number of grid cells. An optical system may be positioned between said converting means and said photon-receptive means. Such optical system is arranged to direct the photons created at a certain location by said converting means towards a corresponding location in said photon- receptive means. The optical system is in an embodiment a magnifying optical system. The said mark is attached to said converting means. The said charged particles beam tool is in particular embodied as en electron beam tool. The electron beam tool is more in particular a lithography system.

Apart from the concepts and all pertaining details as described in the preceding, the invention is defined by the claims.

In the following set of claims, rather than fixating the meaning of a preceding term, any reference numbers corresponding to structures in the figures are for reason of support at reading the claim, included solely as an exemplary meaning of said preceding term.

## Claims

1. A method of measuring properties of a massive amount of charged particle beams (4) of a charged particle beam system, in particular a direct write lithography system, method comprising the steps of:
- converting the charged particle beams (4) into light beams (5) by using a converter element (1),
- using an array of light sensitive detectors (3) such as diodes, CCD or CMOS devices, located in line with said converter element, for detecting said light beams,
- electronically reading out resulting signals from said light sensitive detectors (3) after exposure thereof by said light beams, utilising said signals for determining values for one or more charged particle beam properties, thereby using an automated electronic calculator (CU), wherein said determining of charged particle beam properties is performed on the basis of a set of signals resulting from a converted charged particle beam (4); thereby using a charged particle blocking element (6, 6B, 6B 1, 6B2, 6C), included at a known position relative to the converter element (1), such that said set of signals is obtained by scanning a charged particle beam over the charged particle blocking element such that the charged particle blocking element and the charged particle beam are mutually shifted relative to one another;
- electronically adapting the charged particle system so as to correct for out of specification range values for all or a number of said charged particle beams, each for one or more properties, based on said calculated property values.

2. Method according to claim 1, in which the charged particle blocking element (6, 6B, 6B1, 6B2, 6C) is applied integrated with said converter element, located in close proximity of the top of said converter element, in particular on top thereof.

3. Method according to any one of the preceding claims, wherein adaptation of the system is performed by at least one of
- electronically modifying electronic data, in particular control data, for a pattern to be imaged by said charged particle beam system,
- modifying line width, and
- electronically influencing a position modifying means of said beam system, for modifying the position of one or more charged particle beams, in particular by introducing a time delay.

4. Method according to any one of the preceding claims, in which the spot size of said charged particle beams is smaller than the resolution of the converter element, preferably in which variation of the intensity of a light beam due to passage of said charged particle beams over said charged particle blocking element and said converter element is utilised for determining a beam property value, preferably in which a knife-edge is used in combination with said light intensity for deriving a value for a spot size in one direction or in at least two, in particular three directions, is used for deriving a spot shape.

5. Method according to any one of the preceding claims, wherein determination of beam properties is performed on the basis of a plurality of signals resulting from a stepping proceed of a charged particle beam being scanned in one direction at a time over said charged particle blocking element, preferably in which a charged particle beam is switched off and on during such scan, in particular at predefined instances in time, preferably wherein a switching "off" and "on" is incrementally delayed during multiple scans in one direction, relative to the starting point of the scan, preferably wherein pulse duration variation is determined using a measurement with predetermined beam on/off timing.

6. Method according to any one of the preceding claims, wherein a number of beam properties is derived using a charged particle beam detector comprising a charged particle beam blocking element (6, 6B, 6B1, 6B2, 6C), a converter element (1), an electronically readable photon receptor element (2), an actuator for realising a relative movement of an electron beam and a charged particle blocking element, and an electronic calculating unit (Cu), said beam properties at least including one or more of beam position, timing delay of a possible blanker device acting upon said charged particle beam, beam spot size, beam current and blanking element functioning.

7. A method according to any one of the preceding claims, wherein the charged particle beam system, at least the beam generating part thereof, is provided with an optical sensor, and wherein the charged particle beam detector for detecting beam properties, in particular the pattern of blocking elements (6, 6B, 6B1, 6B2, 6C) thereon is utilised for optically detecting the position of said charged particle beam system relative to an independently moveable stage for holding a target surface and comprising said charged particle beam detector.

8. A sensor (S) configured to measure one or more characteristics of one or more charged particle beams (4), such as in a lithography system and such as in a multi beam inspection tool, said sensor (S) comprising:
- a converter element (1) configured to convert a charged particle beam (4) into a light beam (5),
- a light sensitive detector (3) configured to receive a light beam (5) emitted by said converter element (1) upon incidence of a charged particle beam (4) and configured to transform light from said received light beam into an electronic signal, enabling read out of said signal from the sensor by an electronic control system, a charged particle beam blocking element (6, 6B, 6B1, 6B2, 6C)
applied integrated with the converter element and provided on top of the surface of said converter element (1), the charged particle beam blocking element being provided with a number of knife edges (E1, E2, E3; C1, C2, C3) as taken perpendicularly to the surface of the converter element,
**characterised in that**
the charged particle blocking element is composed of a heavy metal and **in that** the sensor, in the pathway of an electron beam in the sensor, further comprises a thin layer for blocking background light included between the charged particle beam blocking element and the converter element.

9. A sensor according to claim 8, wherein for each beamlet of said lithography system or said multi beam inspection tool a separate charged particle blocking element is provided, in particular included at a known relative position.

10. A sensor according to any one of claims 8 or 9, wherein the heavy material has a thickness within a range from 50 to 500 nm, in particular thick enough to sufficiently block an incoming charged particle beam, and on the other hand thin enough to minimize defocus and edge roughness effects, and wherein, preferably, said heavy material is tungsten.

11. A sensor according to any one of the claims 8-10, wherein the sensor includes a thin layer of light metal such as aluminum, between said knife edge and said converter element, in particular of a thickness within the range from 30 to 80 nm, and/or wherein the sensor includes at least one charged particle blocking element having three sharp edges mutually included in hexagon shape, in particular under an angle with nominal value of 120 degrees.

12. A sensor according to any one of the claims 8-11, in which an optical system is included between the converter element (1) and the light sensitive detector (3).

13. A lithography system configured to transfer a pattern onto the surface of a target, said lithography system comprising:
- a charged particle beam tool, said tool being configured to generate a plurality of charged particle beams (4) for writing said pattern on said surface,
- a blanker part configured to turn off and on each charged particle beam (4) separately during the writing of said pattern onto the surface, and
- a sensor (S) according to any one of claims 8-12 included in a position apart from said target surface, said sensor being arranged in the system for directly detecting all of said charged particle beams (4) simultaneously, the converter element (1) of the sensor being configured to convert each of said charged particle beams (4) into a light beam (5) the sensor further comprising an array of light sensitive elements (3) such as photodiode elements, configured to detect such light beams (5) and configured to generate an electronic signal upon exposure to light;
the system being configured to scan said charged particle beam relative to the sensor and thereby relative to said knife edges of the sensor;
wherein said lithography system is configured for, at least in advance of a writing action, sensing characteristics of a charged particle beam (4) using said sensor (S), and the lithography system further comprising
- a calculating unit configured to at least virtually simultaneously reading out said array of light
sensitive elements, and
- a controller (CM) of the particle beam tool, and/or a controller for said pattern; said calculating unit being configured to provide correcting value signals (COR) upon such read out to said controller (CM) of the particle beam tool, and/or to said controller for said pattern, such that electronic data representing said pattern is modified.

14. A system according to claim 13, configured to perform adaptation of the system by at least one of
- electronically modifying electronic data, in particular control data, for a pattern to be imaged by said charged particle beam system,
- modifying line width, and
- electronically influencing a position modifying means of said beam system, for modifying the position of one or more charged particle beams.

15. System according to any one of claims 13 or 14, in which the calculating unit (CU) is configured to, based on information from the sensor, provide corrective values (COR) for correcting one or more of the position of a particle beam (4) in two directions of a plane preferably parallel to that of the target area, the intensity or current of the particle beam, the spot position and the spot size, and the sigma, of a Gaussian distribution feature of the particle beam (4).

16. System according to any one of claims 13-15, configured to in which a particle beam is scanned over said sensor and switched on at an instance where it is expectedly located at a predetermined position, in particular thereby determining position and timing error of a writing beam, preferably in which the beam is switched on for a pre-determined period of time, in particular thereby determining a pulse duration variation error.

17. System according to any one of claims 13-16, configured to perform multiple scans of the charged particle beam over the sensor (S), and/or configured to scan a charged particle beam over the sensor in three different directions, preferably mutually distributed in a plane under corresponding angles.

18. System according to any one of claims 13-17, configured to scan a charged particle beam for a multiplicity of steps in a single direction over a sensor at different locations, shifted over at least three times an expected or determined spot diameter of the beam.

19. System according to any one of claims 13-18, in which said sensor (S) is configured for measuring both physical displacement of a beam spot and time delay of a blanking part for blanking a beam.

20. A Lithography system comprising a stage for an object such as a wafer or mask to be processed by a multi beam charged particle tool, said stage being provided with a multiplicity of sensors according to any one of claims 8-12 for measuring charged particle beam features, wherein each sensor of said multiplicity is implemented for measuring all charged particle beams of said tool at a time, and wherein sensors of said multiplicity are distributed at various locations near said object to be processed, at mutual distances that are distributed such that calibration of the beam tool is enabled more than once at entirely treating a wafer, in particular thus enabling entire treatment efficiently, i.e. without significant loss of throughput of the system as compared to a single sensor system,
wherein said enabling is realised by distributing at least two sensors at even, at least corresponding distances with respect to the track which the beam tool is to follow relative to said object to be processed.

## Patentansprüche

1. Verfahren zum Messen von Eigenschaften einer großen Menge von Ladungsträgerstrahlen (4) eines Ladungsträgerstrahlsystems, insbesondere eines direkt schreibenden Lithographiesystems, wobei das Verfahren die Schritte umfasst:
umwandeln der Ladungsträgerstrahlen (4) in Lichtstrahlen (5) unter Verwendung eines Wandlerelements (1),
verwenden einer Anordnung von lichtempfindlichen Detektoren (3) wie Dioden, CCD- oder CMOS-Vorrichtungen, die mit dem Wandlerelement ausgerichtet sind, zum Detektieren der Lichtstrahlen,
elektronisches Auslesen von resultierenden Signalen aus den lichtempfindlichen Detektoren (3) nach deren Belichtung durch die Lichtstrahlen, Auswerten der Signale zum Bestimmen von Werten für eine oder mehrere Ladungsträgerstrahleigenschaften unter Verwendung einer automatischen elektronischen Rechnereinheit (CU), wobei das Bestimmen von Ladungsträgerstrahleigenschaften auf der Grundlage eines Satzes von Signalen, die aus einem umgewandelten Ladungsträgerstrahl (4) resultieren, durchgeführt wird, wobei ein Ladungsträgersperrelement (6, 6B, 6B1, 6B2, 6C) verwendet wird, das bei einer bekannten Position relativ zu dem Wandlerelement (1) enthalten ist, so dass der Satz von Signalen durch Abtasten eines Ladungsträgerstrahls über das Ladungsträgersperrelement erhalten wird, so dass das Ladungsträgersperrelement und der Ladungsträgerstrahl relativ zueinander verschoben werden;
elektronisches Anpassen des Ladungsträgerstrahlsystems, um Werte außerhalb des Spezifikationsbereichs für alle oder eine Anzahl der Ladungsträgerstrahlen, jeweils für eine oder mehrere Eigenschaften, auf der Grundlage der berechneten Eigenschaftswerte zu korrigieren.

2. Verfahren nach Anspruch 1, wobei das Ladungsträgersperrelement (6, 6B, 6B1, 6B2, 6C) mit dem Wandlerelement integriert angewendet wird, in der Nähe der Oberseite des Wandlerelements, insbesondere darauf, angeordnet.

3. Verfahren nach einem der vorhergehenden Ansprüche, wobei die Anpassung des Systems durchgeführt wird durch mindestens einen Schritt von:
- elektronischem Ändern von elektronischen Daten, insbesondere von Steuerdaten, für ein durch das Ladungsträgerstrahlsystem abzubildendes Muster,
- Ändern einer Linienbreite, und
- elektronischem Beeinflussen eines Positionsänderungsmittels des Strahlsystems zum Ändern der Position von einem oder mehreren Ladungsträgerstrahlen, insbesondere durch Einführen einer Zeitverzögerung.

4. Verfahren nach einem der vorhergehenden Ansprüche, in welchem die Punktgröße der Ladungsträgerstrahlen kleiner als die Auflösung des Wandlerelements ist, in welchem vorzugsweise eine Schwankung der Intensität eines Lichtstrahls aufgrund des Durchgangs des Ladungsträgerstrahls über das Ladungsträgersperrelement und das Wandlerelement zur Bestimmung eines Strahleigenschaftswerts verwendet wird, in welchem vorzugsweise eine Messerkante in Kombination mit der Lichtintensität zum Ableiten eines Werts für eine Punktgröße in einer Richtung verwendet wird oder in mindestens zwei, insbesondere drei Richtungen zum Ableiten einer Punktform verwendet wird.

5. Verfahren nach einem der vorhergehenden Ansprüche, wobei eine Bestimmung von Strahleigenschaften auf der Grundlage einer Mehrzahl von Signalen durchgeführt wird, die aus einem schrittweisen Voranschreiten eines Ladungsträgerstrahls, der in einer Richtung zu einer Zeit über das Ladungsträgersperrelement abgetastet wird, resultieren, wobei vorzugsweise ein Ladungsträgerstrahl während der Abtastung aus- und angeschaltet wird, insbesondere zu vorbestimmten Zeitpunkten, wobei vorzugsweise ein Aus- und Anschalten schrittweise während mehrerer Abtastungen in einer Richtung verzögert wird, bezogen auf den Startpunkt der Abtastung, wobei vorzugsweise eine Pulsdauerschwankung unter Verwendung einer Messung mit vorbestimmten Strahl-Ein/Aus-Zeitvorgabe bestimmt wird.

6. Verfahren nach einem der vorhergehenden Ansprüche, wobei eine Anzahl von Strahleigenschaften unter Verwendung eines Ladungsträgerstrahldetektors umfassend ein Ladungsträgersperrelement (6, 6B, 6B1, 6B2, 6C), ein Wandlerelement (1), ein elektronisch lesbares Photonenrezeptorelement (2), einen Stellantrieb zum Erzeugen einer Relativbewegung eines Elektronenstrahls und eines Ladungsträgersperrelements, und eine elektronische Rechnereinheit (Cu) abgeleitet wird, wobei die Strahleigenschaften mindestens eine oder mehrere von einer Strahlposition, einer Zeitverzögerung einer möglichen Ausblendevorrichtung, die auf den Ladungsträgerstrahl wirkt, einer Strahlpunktgröße, einem Strahlstrom und einer Ausblendeelement-Funktionsweise umfasst.

7. Verfahren nach einem der vorhergehenden Ansprüche, wobei das Ladungsträgerstrahlsystem, zumindest dessen Strahlerzeugungsteil, mit einem optischen Sensor versehen ist, und wobei der Ladungsträgerstrahldetektor zum Detektieren von Strahleigenschaften, insbesondere dem Muster von Sperrelementen (6, 6B, 6B1, 6B2, 6C) darauf, zum optischen Detektieren der Position des Ladungsträgerstrahlsystems relativ zu einem unabhängig bewegbaren Tisch zum Halten einer Zieloberfläche und umfassend den Ladungsträgerstrahldetektor verwendet wird.

8. Sensor (S), der konfiguriert ist zum Messen von einer oder mehreren Eigenschaften von einem oder mehreren Ladungsträgerstrahlen (4), wie in einem Lithographiesystem und wie in einem Mehrstrahlinspektionswerkzeug, wobei der Sensor (S) umfasst:
- ein Wandlerelement (1), das zum Wandeln eines Ladungsträgerstrahls (4) in einen Lichtstrahl (5) konfiguriert ist,
- einen lichtempfindlichen Detektor (3), der zum Empfangen eines Lichtstrahls (5), der bei Einfall eines Ladungsträgerstrahls (4) von dem Wandlerelement (1) emittiert wird, konfiguriert ist und zum Wandeln von Licht aus dem empfangenen Lichtstrahl in ein elektronisches Signal konfiguriert ist, wodurch ein Auslesen des Signals von dem Sensor durch ein elektronisches Steuersystem ermöglicht wird,
ein Ladungsträgersperrelement (6, 6B, 6B1, 6B2, 6C), das integriert mit dem Wandlerelement angewendet wird und auf der Oberfläche des Wandlerelements (1) bereitgestellt wird, wobei das Ladungsträgersperrelement mit einer Anzahl von Messerkanten (E1, E2, E3; C1, C2, C3) senkrecht zu der Oberfläche des Wandlerelements bereitgestellt wird,
**dadurch gekennzeichnet, dass**
das Ladungsträgersperrelement aus einem Schwermetall besteht und dass der Sensor, in der Bahn eines Elektronenstrahls in dem Sensor, ferner eine dünne Schicht zum Blockieren von zwischen dem Ladungsträgersperrelement und dem Wandlerelement enthaltenem Hintergrundlicht umfasst.

9. Sensor nach Anspruch 8, wobei für jedes Beamlet des Lithographiesystems oder des Mehrstrahlinspektionswerkzeugs ein separates Ladungsträgersperrelement vorgesehen ist, insbesondere enthalten an einer bekannten relativen Position.

10. Sensor nach einem der Ansprüche 8 oder 9, wobei das Schwermetall eine Dicke in einem Bereich von 50 bis 500 nm aufweist, insbesondere dick genug ist, um einen einfallenden Ladungsträgerstrahl ausreichend zu blockieren, und andererseits dünn genug ist, um Defokussierungs-und Kantenrauigkeitseffekte zu minimieren, und wobei das Schwermetall vorzugsweise Wolfram ist.

11. Sensor nach einem der Ansprüche 8 - 10, wobei der Sensor eine dünne Schicht aus Leichtmetall wie Aluminium zwischen der Messerkante und dem Wandlerelement aufweist, insbesondere mit einer Dicke im Bereich von 30 bis 80 nm, und / oder wobei der Sensor mindestens ein Ladungsträgersperrelement mit drei scharfen Kanten, die zueinander in Hexagon-Form, insbesondere unter einem Winkel mit einem Nennwert von 120 Grad, enthalten sind, umfasst.

12. Sensor nach einem der Ansprüche 8 - 11, in dem ein optisches System zwischen dem Wandlerelement (1) und dem lichtempfindlichen Detektor (3) enthalten ist.

13. Lithographiesystem, das konfiguriert ist zum Übertragen eines Musters auf die Oberfläche eines Ziels, wobei das Lithographiesystem umfasst:
- ein Ladungsträgerstrahlwerkzeug, das zum Erzeugen einer Mehrzahl von Ladungsträgerstrahlen (4) zum Schreiben des Musters auf die Oberfläche konfiguriert ist,
- ein Ausblendeteil, das zum separaten Aus- und Einschalten jedes Ladungsträgerstrahls (4) während des Schreibens des Musters auf die Oberfläche konfiguriert ist, und
- einen Sensor (S) nach einem der Ansprüche 8-12, der in einer Position neben der Zieloberfläche enthalten ist, wobei der Sensor in dem System zum gleichzeitigen direkten Detektieren von allen Ladungsträgerstrahlen (4) angeordnet ist, wobei das Wandlerelement (1) des Sensors zum Wandeln von jedem der Ladungsträgerstrahlen (4) in einen Lichtstrahl (5) konfiguriert ist und der Sensor ferner eine Anordnung von lichtempfindlichen Elementen (3) wie Fotodiodenelementen, die zum Detektieren der Lichtstrahlen (5) konfiguriert sind und zum Erzeugen eines elektronischen Signals bei Belichtung mit Licht konfiguriert sind, umfasst;
wobei das System zum Abtasten eines Ladungsträgerstrahls relativ zu dem Sensor und dadurch relativ zu den Messerkanten des Sensors konfiguriert ist;
wobei das Lithographiesystem zum Abtasten von Eigenschaften eines Ladungsträgerstrahls (4) unter Verwendung des Sensors (S), zumindest vor einem Schreibvorgang, konfiguriert ist, und das Lithographiesystem ferner umfasst:
- eine Rechnereinheit, die konfiguriert ist, um mindestens nahezu gleichzeitig die Anordnung von lichtempfindlichen Elementen auszulesen, und
- ein Steuergerät (CM) des Ladungsträgerstrahlwerkzeugs und / oder ein Steuergerät für das Muster;
wobei die Rechnereinheit zum Bereitstellen von Korrekturwertsignalen (COR) bei einem solchen Auslesen an das Steuergerät (CM) des Ladungsträgerstrahlwerkzeugs und / oder an das Steuergerät für das Muster konfiguriert ist, so dass elektronische Daten, die das Muster darstellen, geändert werden.

14. System nach Anspruch 13, das konfiguriert ist zum Durchführen einer Anpassung des Systems durch mindestens einen Schritt von
- elektronischem Ändern von elektronischen Daten, insbesondere von Steuerdaten, für ein durch das Ladungsträgerstrahlsystem abzubildendes Muster,
- Ändern einer Linienbreite, und
- elektronischem Beeinflussen eines Positionsänderungsmittels des Strahlsystems zum Ändern der Position von einem oder mehreren Ladungsträgerstrahlen.

15. System nach einem der Ansprüche 13 oder 14, in dem die Rechnereinheit (CU) konfiguriert ist zum Bereitstellen von Korrekturwerten (COR), auf der Grundlage von Information von dem Sensor, zum Korrigieren von einer oder mehreren von der Position eines Ladungsträgerstrahls (4) in zwei Richtungen einer Ebene, vorzugsweise parallel zu der von der Zielfläche, der Intensität oder des Flusses des Ladungsträgerstrahls, der Punktposition und der Punktgröße und des Sigmas eines Gaußschen Verteilungsmerkmals des Ladungsträgerstrahls (4).

16. System nach einem der Ansprüche 13 - 15, konfiguriert in dem ein Ladungsträgerstrahl über den Sensor abgetastet wird und zu einem Zeitpunkt angeschaltet wird, wenn er erwartungsgemäß an einer vorbestimmten Position angeordnet ist, wodurch insbesondere ein Positions- und Zeitfehler von einem Schreibstrahl bestimmt wird, wobei vorzugsweise der Strahl für eine vorbestimmte Zeitperiode eingeschaltet wird, wodurch insbesondere ein Pulsdauerschwankungsfehler bestimmt wird.

17. System nach einem der Ansprüche 13 - 16, das konfiguriert ist zum Durchführen von mehreren Abtastungen des Ladungsträgerstrahls über den Sensor (S) und / oder konfiguriert ist zum Abtasten eines Ladungsträgerstrahls über den Sensor in drei verschiedenen Richtungen, vorzugsweise gegenseitig in einer Ebene unter entsprechenden Winkeln verteilt.

18. System nach einem der Ansprüche 13 - 17, das konfiguriert ist zum Abtasten eines Ladungsträgerstrahls für eine Mehrzahl von Schritten in einer einzigen Richtung über einen Sensor an verschiedenen Orten, verschoben über mindestens drei Mal einen erwarteten oder bestimmten Punktdurchmesser des Strahls.

19. System nach einem der Ansprüche 13 - 18, wobei der Sensor (S) zum Messen sowohl einer physischen Verschiebung eines Strahlpunkts als auch einer Zeitverzögerung eines Ausblendeteils zum Ausblenden eines Strahls konfiguriert ist.

20. Lithographiesystem, umfassend einen Tisch für ein Objekt wie einen Wafer oder eine Maske, die von einem Mehrstrahl-Ladungsträgerstrahlwerkzeugs zu bearbeiten sind, wobei der Tisch mit einer Mehrzahl von Sensoren nach einem der Ansprüche 8 - 12 zum Messen von Ladungsträgerstrahleigenschaften bereitgestellt wird, wobei jeder Sensor aus der Mehrzahl zum Messen von allen Ladungsträgerstrahlen des Werkzeuges zu einer Zeit ausgebildet ist, und wobei Sensoren aus der Mehrzahl verteilt sind an verschiedenen Orten in der Nähe von dem zu bearbeitenden Objekt in gegenseitigen Abständen, die so verteilt sind, dass eine Kalibrierung des Strahlwerkzeuges beim vollständigen Behandeln eines Wafers mehr als einmal ermöglicht wird, wodurch insbesondere eine gesamte Behandlung effizient ermöglicht wird, d. h. ohne einen wesentlichen Verlust an Durchsatz des Systems im Vergleich zu einem System mit einem einzigen Sensor,
wobei das Ermöglichen durchgeführt wird, indem mindestens zwei Sensoren in gleichen, zumindest entsprechenden Abstände in Bezug auf die Bahn, der das Strahlwerkzeug zu folgen hat, relativ zu dem zu bearbeitenden Objekt verteilt werden.

## Revendications

1. Procédé de mesure de propriétés d'une quantité massive de faisceaux de particules chargées (4) d'un système de faisceaux de particules chargées, en particulier d'un système de lithographie à écriture directe, le procédé comprenant les étapes de :
- conversion des faisceaux de particules chargées (4) en faisceaux lumineux (5) en utilisant un élément de convertisseur (1) ;
- utilisation d'un réseau de détecteurs sensibles à la lumière (3) tels que des diodes, des dispositifs CCD ou CMOS, positionné en ligne avec ledit élément de convertisseur, pour détecter lesdits faisceaux lumineux ;
- lecture électronique de signaux résultants en provenance desdits détecteurs sensibles à la lumière (3) après leur exposition auxdits faisceaux lumineux, en utilisant lesdits signaux pour déterminer des valeurs pour une ou plusieurs propriété(s) de faisceau de particules chargées en utilisant à cette fin un calculateur électronique automatisé (CU), dans lequel ladite détermination de propriétés de faisceau de particules chargées est réalisée sur la base d'un jeu de signaux résultant d'un faisceau de particules chargées (4) converti ; en utilisant à cette fin un élément de blocage de particules chargées (6, 6B, 6B1, 6B2, 6C) inclus en une position connue par rapport à l'élément de convertisseur (1) de telle sorte que ledit jeu de signaux soit obtenu en balayant un faisceau de particules chargées sur l'élément de blocage de particules chargées de telle sorte que l'élément de blocage de particules chargées et le faisceau de particules chargées soient mutuellement décalés l'un par rapport à l'autre ;
- adaptation électronique du système de faisceaux de particules chargées de manière à corriger, quant à un état hors valeurs de plage de spécification, tous lesdits faisceaux de particules chargées ou un certain nombre d'entre eux, à raison de chacun pour une ou plusieurs propriété(s), sur la base desdites valeurs de propriété calculées.

2. Procédé selon la revendication 1, dans lequel l'élément de blocage de particules chargées (6, 6B, 6B1, 6B2, 6C) est intégré avec ledit élément de convertisseur, est positionné à proximité étroite de la partie sommitale dudit élément de convertisseur, en particulier sur sa partie sommitale.

3. Procédé selon l'une quelconque des revendications précédentes, dans lequel une adaptation du système est réalisée au moyen d'au moins l'une des actions qui suivent :
- la modification électronique de données électroniques, en particulier de données de commande, en ce qui concerne un motif destiné à être imagé par ledit système de faisceaux de particules chargées ;
- la modification d'une largeur de ligne ; et
- l'influence électronique d'un moyen de modification de position dudit système de faisceaux, pour modifier la position d'un ou de plusieurs faisceau(x) de particules chargées, en particulier en introduisant un retard temporel.

4. Procédé selon l'une quelconque des revendications précédentes, dans lequel la dimension de spot desdits faisceaux de particules chargées est inférieure à la résolution de l'élément de convertisseur, de façon préférable dans lequel une variation de l'intensité d'un faisceau lumineux due à un passage desdits faisceaux de particules chargées sur ledit élément de blocage de particules chargées et sur ledit élément de convertisseur est utilisée pour déterminer une valeur de propriété de faisceau, de façon préférable dans lequel un tranchant est utilisé en combinaison avec ladite intensité lumineuse pour dériver une valeur pour une dimension de spot dans une seule direction ou dans au moins deux directions, en particulier dans trois directions, pour dériver une forme de spot.

5. Procédé selon l'une quelconque des revendications précédentes, dans lequel une détermination de propriétés de faisceau est réalisée sur la base d'une pluralité de signaux résultant d'un pas à pas procéder d'un faisceau de particules chargées qui est balayé dans une seule direction à la fois sur ledit élément de blocage de particules chargées, de façon préférable dans lequel un faisceau de particules chargées est commuté dans l'état désactivé et dans l'état activé pendant chaque balayage, en particulier selon des occurrences temporelles prédéfinies, de façon préférable dans lequel une commutation dans l'état désactivé et dans l'état activé est retardée par incréments pendant de multiples balayages dans une seule direction, par rapport au point de départ du balayage, de façon préférable dans lequel une variation de durée d'impulsion est déterminée en utilisant une mesure selon un cadencement d'activation/de désactivation de faisceau prédéterminé.

6. Procédé selon l'une quelconque des revendications précédentes, dans lequel un certain nombre de propriétés de faisceau sont dérivées en utilisant un détecteur de faisceau de particules chargées comprenant un élément de blocage de faisceau de particules chargées (6, 6B, 6B1, 6B2, 6C), un élément de convertisseur (1), un élément de récepteur de photons lisible électroniquement (2), un actionneur pour réaliser un déplacement relatif d'un faisceau d'électrons et d'un élément de blocage de particules chargées et une unité de calcul électronique (Cu), lesdites propriétés de faisceau incluant au moins une ou plusieurs propriété (s) prise (s) parmi une position de faisceau, un retard de cadencement d'un dispositif de suppression éventuel qui agit sur ledit faisceau de particules chargées, une dimension de spot de faisceau, un courant de faisceau et un fonctionnement de l'élément de suppression.

7. Procédé selon l'une quelconque des revendications précédentes, dans lequel le système de faisceaux de particules chargées, au moins sa partie de génération de faisceau, est muni d'un capteur optique, et dans lequel le détecteur de faisceau de particules chargées pour détecter des propriétés de faisceau, en particulier le motif d'éléments de blocage (6, 6B, 6B1, 6B2, 6C) dessus, est utilisé pour détecter optiquement la position dudit système de faisceaux de particules chargées par rapport à un plateau qui peut être déplacé de manière indépendante pour supporter une surface cible et comprenant ledit détecteur de faisceau de particules chargées.

8. Capteur (S) configuré pour mesurer une ou plusieurs caractéristique(s) d'un ou de plusieurs faisceau(x) de particules chargées (4), tel que dans un système de lithographie et tel que dans un outil d'inspection à multiples faisceaux, ledit capteur (S) comprenant :
- un élément de convertisseur (1) configuré de manière à convertir un faisceau de particules chargées (4) en un faisceau lumineux (5) ;
- un détecteur sensible à la lumière (3) configuré de manière à recevoir un faisceau lumineux (5) émis par ledit élément de convertisseur (1) suite à l'arrivée en incidence d'un faisceau de particules chargées (4) et configuré de manière à transformer une lumière en provenance dudit faisceau lumineux reçu selon un signal électronique, ce qui permet la lecture dudit signal en provenance du capteur par un système de commande électronique ;
- un élément de blocage de faisceau de particules chargées (6, 6B, 6B1, 6B2, 6C) intégré avec l'élément de convertisseur et prévu sur la partie sommitale de la surface dudit élément de convertisseur (1), l'élément de blocage de faisceau de particules chargées étant muni d'un certain nombre d'arêtes tranchantes (E1, E2, E3 ; C1, C2, C3) tel que pris perpendiculairement à la surface de l'élément de convertisseur,
**caractérisé en ce que** l'élément de blocage de particules chargées est réalisé en un métal lourd et **en ce que** le capteur, dans le passage d'un faisceau électronique dans le capteur, comprend en outre une couche mince pour bloquer une lumière de fond incluse entre l'élément de blocage de faisceau de particules chargées et l'élément de convertisseur.

9. Capteur selon la revendication 8, dans lequel, pour chaque petit faisceau dudit système de lithographie ou dudit outil d'inspection à multiples faisceaux, un élément de blocage de particules chargées séparé est prévu, en particulier est inclus en une position relative connue.

10. Capteur selon l'une quelconque des revendications 8 et 9, dans lequel le matériau lourd présente une épaisseur à l'intérieur d'une plage de 50 à 500 nm, en particulier il est assez épais pour bloquer de manière suffisante un faisceau de particules chargées arrivant et par ailleurs, il est assez mince pour minimiser des effets de défocalisation et de rugosité d'arête tranchante et dans lequel, de façon préférable, ledit matériau lourd est du tungstène.

11. Capteur selon l'une quelconque des revendications 8 à 10, dans lequel le capteur inclut une couche mince en un métal léger tel que l'aluminium, entre ladite arête tranchante et ledit élément de convertisseur, en particulier d'une épaisseur à l'intérieur de la plage qui va de 30 à 80 nm, et/ou dans lequel le capteur inclut au moins un élément de blocage de particules chargées comportant trois arêtes tranchantes acérées mutuellement incluses dans une forme hexagonale, en particulier sous un angle présentant une valeur nominale de 120 degrés.

12. Capteur selon l'une quelconque des revendications 8 à 11, dans lequel un système optique est inclus entre l'élément de convertisseur (1) et le détecteur sensible à la lumière (3).

13. Système de lithographie configuré de manière à transférer un motif sur une surface d'une cible, ledit système de lithographie comprenant:
- un outil à faisceaux de particules chargées, ledit outil étant configuré de manière à générer une pluralité de faisceaux de particules chargées (4) pour écrire ledit motif sur ladite surface ;
- une partie de moyen de suppression configurée de manière à désactiver et à activer chaque faisceau de particules chargées (4) séparément pendant l'écriture dudit motif sur la surface ; et
- un capteur (S) selon l'une quelconque des revendications 8 à 12 inclus en une position à distance de ladite surface cible, ledit capteur étant agencé dans le système de manière à détecter directement tous lesdits faisceaux de particules chargées (4) simultanément, l'élément de convertisseur (1) du capteur étant configuré de manière à convertir chacun desdits faisceaux de particules chargées (4) en un faisceau lumineux (5), le capteur comprenant en outre un réseau d'éléments sensibles à la lumière (3) tels que des éléments de photodiode, configuré de manière à détecter ces faisceaux lumineux (5) et configuré de manière à générer un signal électronique suite à une exposition à la lumière,
le système étant configuré de manière à balayer ledit faisceau de particules chargées par rapport au capteur et par conséquent par rapport auxdites arêtes tranchantes du capteur ; dans lequel ledit système de lithographie est configuré de manière à, au moins avant une action d'écriture, détecter des caractéristiques d'un faisceau de particules chargées (4) en utilisant ledit capteur (S), et le système de lithographie comprenant en outre:
- une unité de calcul configurée de manière à au moins virtuellement lire simultanément ledit réseau d'éléments sensibles à la lumière; et
- un contrôleur (CM) de l'outil à faisceaux de particules et/ou un contrôleur pour ledit motif,
ladite unité de calcul étant configurée de manière à assurer la correction de signaux de valeur (COR) suite à la lecture dudit contrôleur (CM) de l'outil à faisceaux de particules et/ou dudit contrôleur pour ledit motif de telle sorte que des données électroniques représentant ledit motif soient modifiées.

14. Système selon la revendication 13, configuré de manière à réaliser une adaptation du système au moyen d'au moins une action prise parmi :
- la modification électronique de données électroniques, en particulier de données de commande, en ce qui concerne un motif destiné à être imagé par ledit système de faisceaux de particules chargées ;
- la modification d'une largeur de ligne ; et
- l'influence électronique d'un moyen de modification de position dudit système de faisceaux, pour modifier la position d'un ou de plusieurs faisceau(x) de particules chargées.

15. Système selon l'une quelconque des revendications 13 et 14, dans lequel l'unité de calcul (CU) est configurée de manière à, sur la base d'une information en provenance du capteur, fournir des valeurs de correction (COR) pour corriger une ou plusieurs caractéristique(s) prise(s) parmi la position d'un faisceau de particules (4) dans deux directions d'un plan de façon préférable parallèle à celui de la zone cible, l'intensité ou le courant du faisceau de particules, la position de spot et la dimension de spot et le sigma d'une caractéristique de distribution gaussienne du faisceau de particules (4).

16. Système selon l'une quelconque des revendications 13 à 15, configuré de sorte qu'un faisceau de particules soit balayé sur ledit capteur et soit commuté dans l'état activé pour une occurrence pour laquelle on s'attend à ce qu'il soit situé en une position prédéterminée, en particulier de manière à déterminer ainsi une erreur de position et de cadencement d'un faisceau d'écriture, de façon préférable dans lequel le faisceau est commuté dans l'état activé pendant une période temporelle prédéterminée, en particulier de manière à déterminer ainsi une erreur de variation de durée d'impulsion.

17. Système selon l'une quelconque des revendications 13 à 16, configuré de manière à réaliser de multiples balayages du faisceau de particules chargées sur le capteur (S) et/ou configuré de manière à balayer un faisceau de particules chargées sur le capteur dans trois directions différentes, de façon préférable distribuées mutuellement dans un plan sous des angles correspondants.

18. Système selon l'une quelconque des revendications 13 à 17, configuré de manière à balayer un faisceau de particules chargées pour une multiplicité de marches dans une unique direction sur un capteur en des emplacements différents, décalé d'une valeur d'au moins trois fois un diamètre de spot attendu ou prédéterminé du faisceau.

19. Système selon l'une quelconque des revendications 13 à 18, dans lequel ledit capteur (S) est configuré de manière à mesurer à la fois un déplacement physique d'un spot de faisceau et un retard temporel d'une partie de suppression pour supprimer un faisceau.

20. Système de lithographie comprenant un plateau pour un objet tel qu'une plaquette ou qu'un masque destiné(e) à être traité(e) par un outil à particules chargées à multiples faisceaux, ledit plateau étant muni d'une multiplicité de capteurs selon l'une quelconque des revendications 8 à 12 pour mesurer des caractéristiques de faisceau de particules chargées, dans lequel chaque capteur de ladite multiplicité est mis en oeuvre pour mesurer tous les faisceaux de particules chargées dudit outil à la fois et dans lequel des capteurs de ladite multiplicité sont distribués en divers emplacements à proximité dudit objet destiné à être traité, selon des distances mutuelles qui sont distribuées de telle sorte qu'un étalonnage de l'outil à faisceaux soit rendu possible plus d'une fois lors du traitement complet d'une plaquette, en particulier en permettant ainsi un traitement complet de manière efficiente, c'est-à-dire sans perte significative de débit du système par comparaison avec un système à un seul capteur, dans lequel :
ladite possibilité est réalisée en distribuant au moins deux capteurs à égalité, selon au moins des distances correspondantes par rapport au cheminement que l'outil à faisceaux doit suivre en relation avec ledit objet destiné à être traité.
